# EUROPÄISCHE PATENTSCHRIFT

(11) **EP 0 920 955 B1**
(45) Veröffentlichungstag und Bekanntmachung des Hinweises auf die Patenterteilung: **18.02.2004**
(21) Anmeldenummer: 98121188.1
(22) Anmeldetag: 13.11.1998
(51) Int. Cl.: B24B 37/04, B24B 49/04, B24B 49/12, H01L 21/304

(54) **Vorrichtung zur Endpunktkontrolle beim Polieren von Bauelementen, insbesondere Halbleiterbauelementen**
Apparatus for endpoint detection in polishing of components, especially semiconductor components
Dispositif pour la détermination de l'étape finale lors du polissage de composants, en particulier de composants semiconducteurs

(30) Priorität: 03.12.1997 DE 19753691
(43) Veröffentlichungstag der Anmeldung: 09.06.1999
(73) Patentinhaber: Infineon Technologies AG, 81669 München (DE)
(72) Erfinder: Bradl, Stephan, Dr., 93096 Köfering (DE); Heitzsch, Olaf, Dr., 01640 Coswig (DE)
(74) Vertreter: Reinhard - Skuhra - Weise & Partner

(56) Entgegenhaltungen:
- EP-A- 0 738 561
- EP-A- 0 806 266
- US-A- 5 605 760

## Beschreibung

Die vorliegende Erfindung betrifft eine Vorrichtung zur Endpunktkontrolle beim Polieren von Bauelementen, insbesondere Halbleiterbauelementen, gemäß dem Oberbegriff des Anspruchs 1, wie aus der EP 0 806 266 A2 bekannt.

Aus der EP 0 738 561 A1 bzw. der US 5,605,760 A sind fensterlose rotlichtdurchlässige Pads bekannt.

Die Schichtdickenbestimmung und -kontrolle ist bei der Produktion von Halbleiterbauelementen ein unabdingbares Hilfsmittel für die Prozeßsteuerung und Prozeßkontrolle. So ist es beispielsweise beim Chemisch-Mechanischen-Polieren (CMP) möglich, die Schichtdicken von Bauelementen -beispielsweise von Wafern- während des Prozesses online zu messen.

Solche Schichtdickenbestimmungen können mit Hilfe von Ellipsometern oder durch Interferometrie vorgenommen werden.

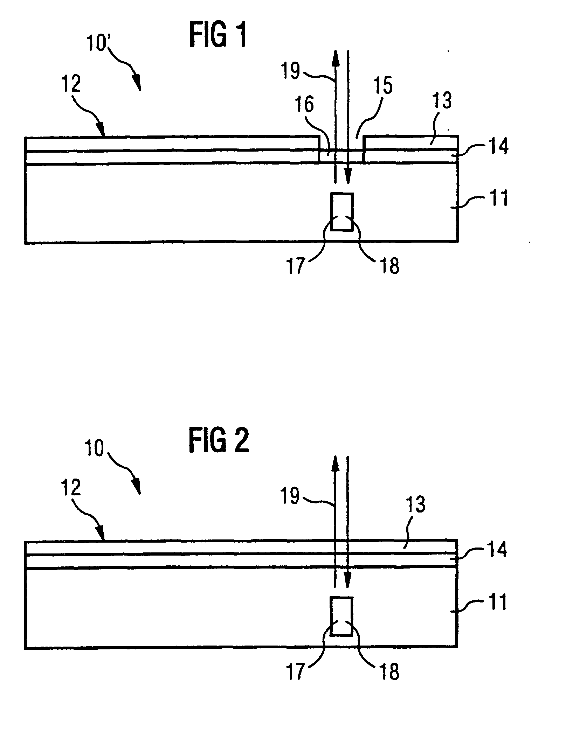

Im Rahmen der Interferometrie ist beispielsweise die Laserinterferenzmessung zu nennen. Um die Schichtdicke zu bestimmen, wird der Wafer durch das beim CMP-Verfahren verwendete Polierpad oder Poliertuch hindurch gescannt. Diese Polierpads oder -tücher sind derzeit so ausgebildet, daß sie Licht durchlässig sind. Üblicherweise werden aus mehreren Lagen bestehende Pads oder Tücher verwendet, in denen ein Fenster eingeklebt ist, das für die jeweilig verwendeten Wellenlängen transparent ist. Ein solches Pad oder Tuch ist in Fig.1 dargestellt und wird im Rahmen der Figurenbeschreibung näher erläutert. Diese Pads oder Tücher sind in ihrer Herstellung mit entsprechend hohen Kosten verbunden und können außerdem mit zunehmendem Abtrag des Pads oder Tuchs zu einer erhöhten Defektdichte führen. Dadurch müssen die Pads oder Tücher häufig ausgewechselt werden, wodurch das Verfahren zur Endpunktkontrolle relativ zeit- und kostenintensiv ist.

Ausgehend vom genannten Stand der Technik liegt der vorliegenden Erfindung die Aufgabe zugrunde, eine Vorrichtung zur Endpunktkontrolle beim Polieren von Bauelementen bereitzustellen, bei der die im Stand der Technik genannten Nachteile vermieden werden. Insbesondere soll eine Vorrichtung geschaffen werden, mit der die Endpunktkontrolle auf billige Weise zuverlässig und ohne besondere Zeitverzögerungen während des Prozesses möglich ist.

Gelöst wird die Ausgabe gemäß einem ersten Aspekt der Erfindung durch eine Vorrichtung zur Endpunktkontrolle beim Polieren von Bauelementen, insbesondere Halbleiterbauelementen, gemäss Anspruch 1.

Es wurde festgestellt, daß handelsübliche textilartige Gebilde, die keinerlei Fenster aufweisen, mit rotem Licht durchstrahlt werden können, ohne daß das Licht von dem textilen Gebilde vollständig absorbiert wird. Solche textilartigen Gebilde sind beispielsweise Gewebe, Tücher oder Pads, die bei der Produktion von Halbleiterbauelementen Verwendung finden, wie etwa als Poliermaterialien im CMP-Verfahren. Allerdings ist die Erfindung nicht auf diese Art von Bauelementen und textilen Gebilden beschränkt. Als Lichtquelle kann jede Lichtquelle dienen, die ein rotes, monochromatisches Licht erzeugt.

Erfindungsgemäß weisen die textilartigen Gebilde nunmehr eine fensterfreie Struktur auf. Das bedeutet, daß auf die bisher üblichen textilen Gebilde mit eingearbeitetem Fenster, wie sie aus dem Stand der Technik bekannt sind, verzichtet wird. Dadurch können zunächst die Kosten erheblich reduziert werden. Weiterhin ist die Gefahr ausgeschlossen, daß mit zunehmendem Abtrag der textilen Gebilde eine erhöhte Defektdichte auf den Oberflächen der Bauelemente auftritt. Diese Gefahr ergibt sich aus der Tatsache, daß die Fenster aus einem anderen, härteren Material als das übrige textile Gebilde hergestellt sind, so daß eine Berührung der oftmals empfindlichen Oberflächen der Bauelemente mit dem Fenstermaterial zu Beschädigungen wie Kratzern oder dergleichen führen kann. Durch die Verwendbarkeit von textilen Gebilden mit fensterfreier Struktur (das heißt textile Gebilde ohne eingearbeitete Fenster) wird somit die Lebensdauer der textilen Gebilde erhöht, wodurch die Stillstandzeiten beim Verfahren sowie die Kosten weiter reduziert werden können. Weiterhin können Instabilitäten im Verfahren und eine eingeschränkte Anwendbarkeit der textilen Gebilde aufgrund unterschiedlicher Materialien im textilen Gebilde vermieden werden. Auch können unterschiedliche Eigenschaften des textilen Gebildes im Bereich des Fenstermaterials und im Bereich des übrigen Gebildes, wie beispielsweise unterschiedliche Kompressibilität, Härte oder Saugfähigkeit gegenüber Slurry und Wasser ausgeschlossen werden.

Mit der erfindungsgemäßen Vorrichtung ist es demnach möglich, daß bei der Endpunktkontrolle von Wafern und anderen Bauteilen, die üblicherweise gleichzeitig während des Herstellungsprozesses erfolgt, handelsübliche textile Gebilde ohne Fenster verwendet werden können.

Dabei ist die Erfindung nicht auf die Endpunktkontrolle beim Polieren von bestimmten Bauteilen beschränkt, kann jedoch bevorzugt im Rahmen der Herstellung von Halbleiterbauelementen, wie beispielsweise Speicher-, Logik-, mikromechanischen oder optischen Bauelementen, eingesetzt werden. Die Bauteile können während des Herstellungsverfahrens in Form von Wafern vorliegen, wobei die zu kontrollierenden Schichten durch das Auftragen von Materialien auf die Waferoberfläche oder aber auch durch das Abtragen von Bereichen der Waferoberflächen, etwa durch Ätzen oder dergleichen gebildet werden können. Die Erfindung ist jedoch nicht auf eine bestimmte Art der Bildung von der zu kontrollierenden Schicht beschränkt.

Bevorzugte Ausgestaltungsformen der erfindungsgemäßen Vorrichtung ergeben sich aus den Unteransprüchen.

In bevorzugter Ausgestaltung kann die Lichtquelle ein Laser sein. Dadurch kann ein optimal gerichteter, gebündelter und intensiver Rotlicht-Strahl bereitgestellt werden.

Erfindungsgemäß kann der von der Lichtquelle abgegebene Rotlicht-Strahl eine Wellenlänge von größer 650nm, vorzugsweise von etwa 800nm aufweisen.

In weiterer Ausgestaltung ist die Intensität der Lichtquelle und/oder die Empfindlichkeit des Detektors regelbar. Dadurch kann die Vorrichtung bei der Endpunktkontrolle beim Polieren der Bauteile je nach Bedarf und herrschenden Prozeßverhältnissen individuell eingestellt werden.

Erfindungsgemäss sind die Lichtquelle und der Detektor in einem einzigen Bauteil ausgebildet. Dadurch wird der konstruktive Aufwand der Vorrichtung verringert.

Das textilartige Gebilde ist auf einer Auflageplatte angeordnet. Die Auflageplatte, auch "Platen" genannt, dient der planen Abstützung des textilartigen Gebildes sowie des darauf befindlichen Bauelements, beispielsweise einem Wafer.

Erfindungsgemäß sind die Lichtquelle und der Detektor innerhalb der Auflageplatte angeordnet. Dadurch ist zunächst eine einfache Konstruktion der Vorrichtung möglich. Weiterhin sind die Lichtquelle und der Detektor vor Verunreinigungen und Beschädigungen, die die Meßergebnisse verfälschen könnten, geschützt. Um einen ungestörten Strahlengang des Rotlicht-Strahls zu gewährleisten, ist die Auflageplatte wenigstens im Bereich der Lichtquelle und des Detektors transparent ausgebildet.

Die Erfindung wird nun anhand eines Ausführungsbeispiels unter Bezugnahme auf die beiliegende Zeichnung näher erläutert. Es zeigt:
Fig.1 in schematischer Querschnittsansicht eine aus dem Stand der Technik bekannte Vorrichtung zur Endpunktkontrolle beim Polieren von Bauelementen; und
Fig.2 in schematischer Querschnittsansicht eine erfindungsgemäße Vorrichtung zur Endpunktkontrolle beim Polieren von Bauelementen.

In Fig.1 ist eine Vorrichtung 10' zur Endpunktkontrolle beim Polieren von Bauelementen, insbesondere Halbleiterbauelementen dargestellt, wie sie aus dem Stand der Technik bekannt ist. Die Vorrichtung 10' arbeitet nach dem Prinzip der Laserinterferenz, wobei ein Laser 17 verwendet wird. Die Vorrichtung 10' weist eine Auflageplatte 11 auf, auf der ein textiles Gebilde 12 angeordnet ist. Das textile Gebilde 12 ist als Poliertuch ausgebildet, wie es bei der Bearbeitung von Wafern beim Chemisch-Mechanischen-Polieren (CMP) verwendet wird. Das Poliertuch 12 besteht aus einer oberen Poliertuchschicht 13 und einer unteren Poliertuchschicht 14. Beide Poliertuchschichten 13, 14 weisen eine Fensteröffnung 15 auf. In der unteren Poliertuchschicht 14 ist in der Fensteröffnung 15 eine transparente Fensterfläche 16 eingefügt. Die Fensterfläche 16 hat die Funktion, den von einem Laser 17 abgegebenen monochromatischen Lichtstrahl 19 durchzulassen. Der Laser 17 ist in der Auflageplatte 11 angeordnet. Der Lichtstrahl 19 tritt durch die Fensterfläche 16 und die Fensteröffnung 15 hindurch und trifft auf die Oberfläche des Bauteils, an dem die Endpunktkontrolle vorgenommen werden soll. Das Bauteil, das in Fig.1 nicht dargestellt ist, ist auf der oberen Poliertuchschicht 13 angeordnet. Von der Oberfläche des Bauteils wird der Laserstrahl 19 reflektiert und von einem Detektor 18 erfaßt, der ebenfalls in der Auflageplatte 11 angeordnet ist. Sowohl der Laser 17 als auch der Detektor 18 sind in einem einzigen Bauteil angeordnet. Aufgrund der Interferenzen zwischen den beiden Wellenzügen des vom Laser 17 abgehenden Laserstrahls 19 und dem vom Bauteil reflektierten Laserstrahl 19, der im Detektor 18 erfaßt wird, läßt sich die Endpunktkontrolle, zum Beispiel eine Schichtdickenbestimmung, bei dem Bauelement vornehmen.

Bei dem Poliertuch 12 gemäß Fig.1 ist zunächst von Nachteil, daß dessen Herstellung relativ kompliziert und damit kostenintensiv ist. Weiterhin muß das Poliertuch 12 in bezug auf den Laser 17 und den Detektor 18 genau positioniert werden, um eine Verfälschung der Meßergebnisse zu vermeiden. Insbesondere muß sichergestellt werden, daß die Fensteröffnung 15 immer genau über dem Laser 17 und dem Detektor 18 angeordnet ist, um die ungehinderte Ausbreitung des Laserstrahls 19 zu gewährleisten.

Da das Fenstermaterial aus einem härteren Material besteht als die für die Bearbeitung des Bauelements vorgesehene obere Schicht 13 des Poliertuchs 12, kann bei Abrieb der oberen Schicht 13 eine Beschädigung der empfindlichen Oberfläche des Bauteils durch die härtere Schicht 14 auftreten, etwa in Form von Kratzern oder dergleichen. Weiterhin kann das für die untere Poliertuchschicht 14 und die Fensterfläche 16 verwendete Material zu einer eingeschränkten Anwendbarkeit des Poliertuchs 12 führen, falls das Material nicht mit allen Prozeßbedingungen und -merkmalen sowie den Materialien der Bauelemente kompatibel ist.

Die genannten Nachteile können bei der erfindungsgemäßen Vorrichtung 10 zur Endpunktkontrolle beim Polieren von Bauelementen vermieden werden. Diese Vorrichtung 10 ist in Fig.2 dargestellt. Dabei wurden diejenigen Elemente, die mit Elementen der Vorrichtung 10' aus Fig.1 identisch sind, mit jeweils identischen Bezugsziffern benannt.

Die Vorrichtung 10 gemäß Fig.2 weist eine Auflageplatte 11 auf, auf der ein Poliertuch 12 angeordnet ist. Das Poliertuch weist eine obere Poliertuchschicht 13 und eine untere Poliertuchschicht 14 auf. Das Poliertuch 12 kann jedoch auch einlagig ausgebildet sein. Im Gegensatz zum Poliertuch aus Fig.1 weist das Poliertuch 12 gemäß Fig.2 eine fensterfreie Struktur auf. Auf dem Poliertuch 12 ist ein nicht dargestelltes Bauelement, dessen Schichtdicke bestimmt werden soll, angeordnet. Ein Laser 17 und ein Detektor 18, die in einem einzigen Bauteil zusammengefaßt sind, sind in der Auflageplatte 11 angeordnet. Das vom Laser abgehende Licht ist ein gerichteter, monochromatischer Rotlicht-Strahl 19 mit einer Wellenlänge von etwa 800nm.

Nachfolgend wird nun die Funktionsweise der Vorrichtung 10 beschrieben. Das Bauteil, das beispielsweise ein Wafer sein kann und bei dem die Endpunktkontrolle durchgeführt werden soll, befindet sich auf der oberen Poliertuchschicht 14. Der Rotlicht-Strahl 19 wird vom Laser 17 abgestrahlt und durchdringt das Poliertuch 12, ohne daß dabei das Licht vom Poliertuch 12 vollständig absorbiert wird. Der Rotlicht-Strahl 19 trifft auf die zu kontrollierende Oberfläche des Bauelements und wird von dort reflektiert. Der reflektierte Rotlicht-Strahl 19 wird vom Detektor 18 erfaßt. Aus der Intensität der beiden Strahlen läßt sich mittels Interferenzmessung die Endpunktkontrolle vornehmen. Da das Rotlicht das Poliertuch durchdringen kann, können bei der Vorrichtung 10 herkömmliche Poliertücher ohne Fenster verwendet werden.

## Patentansprüche

1. Vorrichtung zur Endpunktkontrolle beim Polieren von einem Bauelement, insbesondere eines Haibleiterbauelements, mit einem Tuch oder Pad, zur Aufnahme des zu kontrollierenden Bauelements, welches auf einer planaren Oberfläche einer Auflageplatte (11) angeordnet ist, einer Lichtquelle (17) zur Abgabe eines Rotlicht-Strahls (19), der durch das Tuch oder Pad auf das Bauelement gerichtet ist und einem Detektor (18) zur Erfassung des von dem Bauelement reflektierten Rotlicht-Strahls (19), wobei die Lichtquelle (17) und der Detektor (18) in der Auflageplatte (11) angeordnet sind;
**dadurch gekennzeichnet, dass**
die Lichtquelle (17) und der Detektor (18) in einem einzigen Bauteil ausgebildet sind, das vollständig innnerhalb der Auflageplatte (11) angeordnet ist;
die Oberfläche der Auflageplatte (11) über dem einzigen Bauteil mit der Lichtquelle (17) und dem Detektor (18) einen planaren Bereich aufweist, der transparent ausgebildet ist, um einen ungestörten Strahlengang des Rotlicht-Strahls (19) zu gewährleisten; und
das Tuch oder Pad ein textilartiges Gebilde (12) ist, welches eine fensterfreie Struktur aufweist.

2. Vorrichtung nach Anspruch 1, **dadurch gekennzeichnet, daß** die Lichtquelle (17) ein Laser ist.

3. Vorrichtung nach Anspruch 1 oder 2, **dadurch gekennzeichnet, daß** der von der Lichtquelle (17) abgegebene Rotlicht-Strahl (19) eine Wellenlänge von größer 650nm, vorzugsweise von etwa 800nm aufweist.

4. Vorrichtung nach einem der Ansprüche 1 bis 3, **dadurch gekennzeichnet, daß** die Intensität der Lichtquelle (17) und/oder die Empfindlichkeit des Detektors (18) regelbar ist/sind.

## Claims

1. Device for end-point monitoring used in the polishing of a component, in particular a semiconductor component, having a cloth or a pad, for accommodating the component which is to be monitored, which is arranged on a planar surface of a platen (11), a light source (17) for emitting a red light beam (19) which is directed through the cloth onto the component or pad, and a detector (18) for detecting the red light beam (19) reflected by the component, the light source (17) and the detector (18) being arranged in the platen (11);
**characterized in that**
the light source (17) and the detector (18) are provided in a single component which is arranged completely inside the platen (11);
the surface of the platen (11) has, over the single component with the light source (17) and the detector (18), a planar region which is of transparent design in order to ensure that the path of the red light beam (19) is not impeded; and
the cloth or pad is a textile-like structure (12) which has a windowless design.

2. Device according to Claim 1, **characterized in that** the light source (17) is a laser.

3. Device according to Claim 1 or 2, **characterized in that** the red light beam (19) emitted by the light source (17) has a wavelength of greater than 650 nm, preferably of about 800 nm.

4. Device according to one of Claims 1 to 3, **characterized in that** the intensity of the light source (17) and/or the sensitivity of the detector (18) can be adjusted.

## Revendications

1. Dispositif de contrôle final lors du polissage d'un composant, en particulier d'un composant semi-conducteur, avec une étoffe ou un tampon pour recevoir le composant à contrôler, qui est placé sur une surface plane d'une plaque d'appui (11), avec une source lumineuse (17) pour fournir un faisceau de lumière rouge (19) qui est dirigé sur le composant à travers l'étoffe ou le tampon et avec un détecteur (18) pour la détection du faisceau de lumière rouge (19) réfléchi par le composant, la source lumineuse (17) et le détecteur (18) étant placés dans la plaque d'appui (11) ;
**caractérisé en ce que**
la source lumineuse (17) et le détecteur (18) sont conçus dans un seul et même élément qui est entièrement placé à l'intérieur de la plaque d'appui (11) ;
la surface de la plaque d'appui (11) a au-dessus de l'unique élément réunissant la source lumineuse (17) et le détecteur (18) une zone plane qui est conçue transparente afin de garantir un trajet non perturbé du faisceau de lumière rouge (19) ; et
l'étoffe ou le tampon est un produit textile (12) qui a une structure sans fenêtre.

2. Dispositif selon la revendication 1, **caractérisé en ce que** la source lumineuse (17) est un laser.

3. Dispositif selon la revendication 1 ou 2, **caractérisé en ce que** le faisceau de lumière rouge (19) fourni par la source lumineuse (17) a une longueur d'onde supérieure à 650 nm, de préférence d'environ 800 nm.

4. Dispositif selon l'une des revendications 1 à 3, **caractérisé en ce que** l'intensité de la source lumineuse (17) et/ou la sensibilité du détecteur (18) est/sont réglables.
